# EUROPEAN PATENT APPLICATION

(11) **EP 4 530 719 A1**
(43) Date of publication of application: **02.04.2025**
(21) Application number: 24166115.6
(22) Date of filing: 26.03.2024
(51) Int. Cl.: G03F 7/00

(54) **METHOD FOR OPTIMIZING THE EMISSION OF ELECTROMAGNETIC RADIATION OF A PLASMA OF AN ILLUMINATION SYSTEM, SOURCE MODULE, ILLUMINATION SYSTEM, PROJECTION EXPOSURE APPARATUS**

(71) Applicant: Carl Zeiss SMT GmbH, 73447 Oberkochen (DE); ASML Netherlands B.V., 5504 DR Veldhoven (NL)
(72) Inventor: HARRISON, Kramer Daniel, 5504 DR VELDHOVEN (NL); UTINA, Andrei Catalin, 5504 DR VELDHOVEN (NL); CORONEL, Joshua, 5504 DR VELDHOVEN (NL); KOCKEROLS, Jean, 5504 DR VELDHOVEN (NL)
(74) Representative: Raunecker, Klaus Peter

(57) **Abstract**

The invention relates to a method for optimizing the emission of electromagnetic radiation (16) of a plasma (34) in a source (4) of an illumination system (2) of a projection exposure apparatus (1), whereas the illumination system (2) comprises a collector mirror (31), the method comprising following steps:
- Determination of the electromagnetic radiation (16) emitting plasma volume (34),
- Determination of an optimized surface topology (38.1) of the collector mirror
- Deforming the collector mirror (31) according to the determined surface topology (38.1).

Furthermore, the invention relates to a source module (30) with a collector mirror (31), whereas the source is a plasma source and the collector mirror (31) is the first mirror after the source. The source module (30) is characterized in that the collector mirror (31) is deformable.

## Description

The invention relates to a method for optimizing the emission of electromagnetic radiation of a plasma of an illumination system, a source module, an illumination system and a projection exposure apparatus.

Projection exposure apparatuses for semiconductor lithography show a strong dependence on the quality of the illumination of the object plane with regard to their imaging quality. The electromagnetic radiation used for the illumination is generated by an illumination system and a light source, which is referred to hereinafter as the used light source. In the case of EUV lithography, the used light source is a comparatively complex plasma source, by which a plasma that emits electromagnetic radiation in the desired short-wave frequency ranges is generated by means of laser irradiation of tin droplets.

The mirror reflecting part of the used light source, and normally the first mirror reflecting EUV light in the system, is a so-called EUV collector mirror, which collects the EUV light emitted by the plasma and directs it in a condensed form into the illumination system of the EUV projection exposure apparatus. The radiation generated by the used light source in this case comprises not only radiation of the wavelength of the used light, which in the case of an EUV projection exposure apparatus lies in the range from 5 nm to 20 nm, in particular at 13.5 nm, but also radiation components of other wavelengths, such as for example IR radiation. The IR radiation is a radiation that is emitted by the laser for generating the plasma and is not intended to enter the illumination optics unit of the illumination system or the projection optical unit, since it otherwise heats up the optical elements, which has adverse effects on the imaging quality.

The collector mirror focuses the emitted radiation of the plasma, the collector mirror usually comprising a main body, which is produced for example from ceramics or glass. The collector mirror, like other mirrors used in the apparatus, also comprises at least one layer system, for example a molybdenum-silicon multiple layer system, which allows high-precision surface processing and/or a high reflectivity in the desired spectral range. The layer system often also has the task of filtering out undesired radiation components, such as for example the infrared radiation of the plasma and of the laser. For this purpose, specialized sublayers or grating structures may be incorporated in the coating.

The plasma has a specific non-uniform shape and can be influenced by droplet position, parameters used to generate the plasma and other parameters. The plasma can be described as a stack of two-dimensional layers and/or as a three-dimensional volume, the so-called plasma volume. Obtaining the form of the plasma volume in two dimensional maps and/or a three-dimensional plasma volume is known from US 2020/018949 A1 and WO 20222443006 A1. The amount of emitted EUV-Light of the plasma directed by the collector mirror to the illumination optical unit depends strongly on the size, shape, position and orientation of the plasma in relation to the collector mirror. Changes of the plasma volume and/or its position in reference to the collector mirror therefore can lead to a negative impact of the efficiency of the use of the emitted EUV-light of the plasma or less used light to be emitted to the illumination system and hereafter to the projection optics of the projection exposure apparatus, which decreases throughput, which is one of the most important key performance indicators (KPI) for system power and/or system performance.

It is also known from the prior art, as for example from the US patent US 10429729 B2, that different areas of the collector mirror contribute different amounts of emitting light reaching the illumination system. Reasons for this are especially a non-uniform impact of EUV-Light from the plasma onto the mirror and the fact that different regions of the mirror have different contributions to the system power based on angular distribution of emitted EUV-Light, optical and mechanical design, gas flow within the system and the fact that apertures in the illumination system or the projection system are clipping of parts of the EUV-light.

All constant contributors reducing the system power can be optimized or eliminated during the setup of the projection exposure apparatus. The above-mentioned US Patent discloses different methods to increase system performance, as optimization of laser beam shaping for irradiation of the tin droplet and rotation of the collector mirror.

Changes over time though can lead to a significant impact on system performance.

Besides intrinsic changes of the plasma volume, there are also changes due to the fact that the machine set up and especially the adjustment of the plasma and the collector mirror is done using a power setting for generating the plasma, which is significantly lower than the one during the use of the projection exposure apparatus. Additionally, the collector mirror may show non-uniform degradation influencing the emission of the EUV-Light into the illumination optical unit. Any changes in the plasma based on the different power settings in set up and the use of the machine cannot be corrected in the projection exposure apparatus and may have a negative impact on system performance.

The object of the present invention is to make a method available for optimizing the emission of EUV-Light to the illumination optical unit. A further object of the present invention is to provide a device to solve the above-described issues.

This object is achieved by a method and devices having the features of the independent claims. The dependent claims relate to advantageous developments and variants of the invention.

A method according to the invention for optimizing the emission of electromagnetic radiation of a plasma in a source of an illumination system of a projection exposure apparatus, whereas the illumination system comprises a collector mirror, comprises the following steps:
- Determination of the electromagnetic radiation emitting plasma volume.
- Determination of an optimized surface topology of the collector mirror.
- Deforming the collector mirror according to the determined surface topology.

The procedural design of producing the plasma by means of laser irradiation of tin droplets leads to non-uniform plasma volume. Plasma volume is defined by the volume of the plasma emitting electromagnetic radiation, which e.g. is EUV-light and therefore describes the emission of EUV-light from the plasma onto the collector mirror. The emission from this volume is then reflected by the collector mirror into the illumination optical unit of the projection exposure apparatus. Thus, the shape of the volume has a direct impact on system power. The system power is defined as the energy of EUV-light per time reaching the wafer to expose the resist and define the structures on the wafer. The determined plasma volume can therefore be used to optimize the direction of the emitted EUV-Light from the collector mirror to the illumination optical unit. The direction of emitted EUV-light will be defined by the shape of the deformable collector mirror or in other words the shape of the collector mirror will be adjusted in such a way, that emission of EUV-light into the system is optimized. Optimization is based on different boundary conditions described below, but not only on the amount of EUV-light emitted, but rather the distribution of the EUV-light emitted from the plasma.

In particular the emitting plasma volume can be measured in two dimensions, e.g. in layers, thus stacks of the two-dimensional layers can be used to describe the entire plasma volume.

Furthermore, the emitting plasma volume can be measured in three dimensions. The three-dimensional volume measurement can be done by scintillators, e.g. Ce crystals, which fluoresce in the visible spectrum when irradiated with EUV-light. This visible radiation can easily be imaged by high-resolution off-the-shelf cameras. More than one camera may be used in the system, from which a 3D-distribution can be reconstructed.

In a further embodiment of the invention a contribution map of the amount of reflected EUV-Light of the collector mirror to system power can be determined and used as an input to determine the optimized surface topology. The contribution map may include the percentage of contribution of different areas of the collector mirror to the system power. These can be based on incident angles of EUV-Light, optical and mechanical design, gas flow within the system and the fact, that apertures in an illumination optical unit and/or a projection optical unit of the projection exposure apparatus may be clipping parts of the EUV-light. Taking the contribution map into account, when determining the shape of the collector mirror will increase the contributed EUV-light to the system.

Furthermore, the restrictions of the mechanical and optical design of an optical system of the projection exposure apparatus can be used as an input to determine the optimized surface topology. The optimization can therefore not only be based on emitting as much EUV-light into the illumination optical unit as possible, but also in the distribution of the emitted EUV-light. Restrictions may be in particular apertures and gaps between multi mirror mirrors, defining areas in which light will not be reflected. The deformed collector mirror can advantageously avoid emitting EUV-light to these gaps or restrictions, so loss of generated EUV-light will be reduced and therefore increasing system power.

In a further embodiment of the invention the surface topology can be controlled in an open control loop. In this case the plasma volume is given as an input and an optimized surface will be determined and adjusted based on this input. Based on the actuators used to deform the surface a closed loop shape control may be needed. The open loop therefore means in this case, that there is no feedback from the system power, but the shape of the collector mirror is solely based on the plasma volume.

In a further embodiment of the invention the surface topology can be controlled in a closed control loop.

In particular the control of surface topology is part of a closed control loop of a key performance indicator (KPI), such as throughput, dependent on the surface topology. In this case the system power, or any other key performance indicator, can be fed back to the control of the shape of the collector mirror.

A source module according to the invention with a collector mirror, whereas the source is a plasma source and the collector mirror is the first mirror after the source is characterized in that the collector mirror is deformable. This enables to optimize the amount and the distribution of EUV-light emitted from the plasma into the illumination optical unit of the projection exposure apparatus.

Furthermore, the collector mirror can comprise at least one piezoelectric actuator to deform the reflective surface of the collective mirror.

Additionally, the source module can comprise an actuator control unit to control the actuators. The control unit will position the actuators and control their position. Depending on the actuators used there may be sensors needed to control the position of the actuators in the needed accuracy, to ensure the shape of the collector mirror.

In another embodiment the source module can comprise a plasma volume detection unit. The plasma volume detection unit detects the emission of EUV-light from the plasma. The emission can be measured in stacks of two-dimensional layers or in a three-dimensional volume, as described above.

In a further embodiment the source module can comprise a EUV-light emission control unit. This unit comprises the plasma volume detection unit and the actuator control unit.

Additionally, the EUV-light emission control unit can further comprise a sensing unit. The sensing unit gets as a minimum input the shape of the plasma volume from the plasma volume detection unit and determines the optimum shape of the collector mirror for optimization of EUV-light emission. Besides that, further inputs can be provided to the sensing unit, as the emission of EUV-light at the edge of the collector mirror, system power at reticle level or the position of actuatable components within the illumination optical unit or the projection optical unit, to name at least a few. Basically any parameter can be provided to the sensing unit in order to optimize the shape of the collector mirror.

An illumination system according to the invention comprises a source module according to one of the embodiments described above.

A projection exposure apparatus according to the invention comprises an illumination system according to the above-described embodiments.

In particular the projection exposure apparatus can comprise a global control designed to control at least one system performance indicator, whereas the global control includes the EUV-light emission control unit as a sub control loop. The key performance indicator controlled is influenced by the emitted EUV-light from the source besides many other influencing parameters. The control will therefore give feedback to the EUV-light emission control unit. The feedback will be considered by the sensing unit as an additional input to determine the optimum shape of the collector mirror. The control may comprise a machine-learning-module to learn over time and adapt the controller using all available influencing parameters from the projection exposure apparatus to further optimize the emission of EUV-light into the system.

Exemplary embodiments and variants of the invention are explained in more detail below with reference to the drawing, in which:
- Figure 1: schematically shows a meridional section of a projection exposure apparatus for EUV projection lithography,
- Figure 2: shows a first embodiment of the invention,
- Figure 3: shows a detail of the invention, and
- Figure 4: a flow chart showing an inventive process.

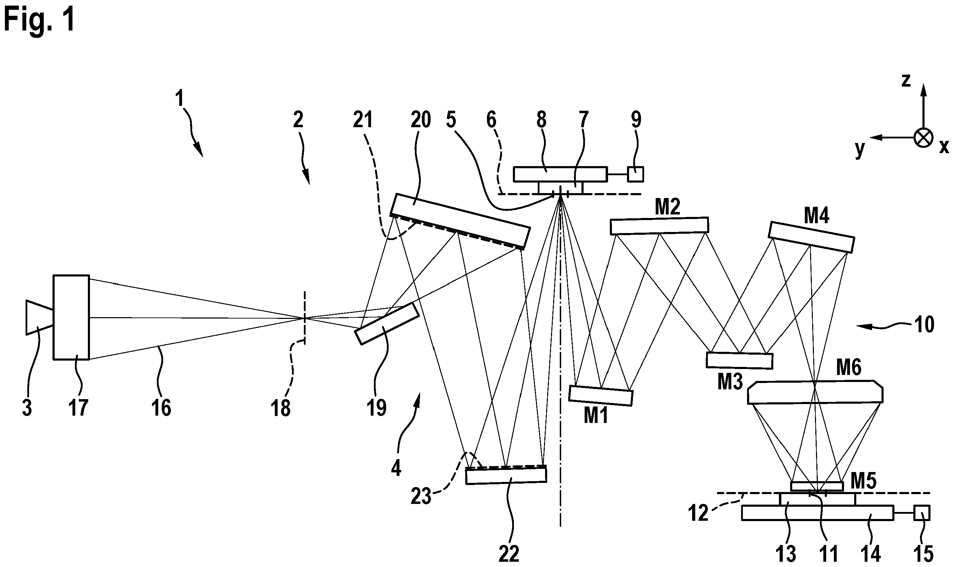

With reference to Figure 1, the essential components of a microlithographic projection exposure apparatus 1 are initially described below in exemplary fashion. The description of the basic structure of the projection exposure apparatus 1 and its components are here not understood to be limiting.

An embodiment of an illumination system 2 of the projection exposure apparatus 1 has, in addition to a radiation source 3, an illumination optical unit 4 for illuminating an object field 5 in an object plane 6. In an alternative embodiment, the light source 3 can also be provided as a separate module from the remaining illumination system. In this case, the illumination system does not comprise the light source 3.

A reticle 7 arranged in the object field 5 is exposed. The reticle 7 is held by a reticle holder 8. The reticle holder 8 is displaceable by way of a reticle displacement drive 9, in particular in a scanning direction.

A Cartesian xyz-coordinate system is shown in Figure 1 for explanation purposes. The x-direction runs perpendicularly to the plane of the drawing into the latter. The y-direction runs horizontally and the z-direction runs vertically. The scanning direction extends along the y-direction in Figure 1. The z-direction runs perpendicular to the object plane 6.

The projection exposure apparatus 1 comprises a projection optical unit 10. The projection optical unit 10 serves for imaging the object field 5 into an image field 11 in an image plane 12. The image plane 12 runs parallel to the object plane 6. Alternatively, an angle between the object plane 6 and the image plane 12 that differs from 0° is also possible.

A structure on the reticle 7 is imaged onto a light-sensitive layer of a wafer 13 arranged in the region of the image field 11 in the image plane 12. The wafer 13 is held by a wafer holder 14. The wafer holder 14 is displaceable by way of a wafer displacement drive 15, in particular along the y-direction. The displacement on the one hand of the reticle 7 by way of the reticle displacement drive 9 and on the other hand of the wafer 13 by way of the wafer displacement drive 15 can take place in such a way as to be synchronized with one another.

The radiation source 3 is an EUV radiation source. The radiation source 3 emits, in particular, EUV radiation 16, which is also referred to below as used radiation, illumination radiation or illumination light. In particular, the used radiation has a wavelength in the range between 5 nm and 30 nm. The radiation source 3 can be a plasma source, for example an LPP source (Laser Produced Plasma) or GDPP source (Gas Discharged Produced Plasma). It can also be a synchrotron-based radiation source. The radiation source 3 can be a free electron laser (FEL).

The illumination radiation 16 emerging from the radiation source 3 is focused by a collector 17. The collector 17 may be a collector with one or more ellipsoidal and/or hyperboloidal reflection surfaces. The illumination radiation 16 may be incident on the at least one reflection surface of the collector 17 with grazing incidence (GI), that is to say at angles of incidence of greater than 45°, or with normal incidence (NI), i.e. at angles of incidence of less than 45°. The collector 17 can be structured and/or coated, firstly, for optimizing its reflectivity for the used radiation and, secondly, for suppressing extraneous light.

Downstream of the collector 17, the illumination radiation 16 propagates through an intermediate focus in an intermediate focal plane 18. The intermediate focal plane 18 may represent a separation between a radiation source module, having the radiation source 3 and the collector 17, and the illumination optical unit 4.

The illumination optical unit 4 comprises a deflection mirror 19 and, arranged downstream thereof in the beam path, a first facet mirror 20. The deflection mirror 19 may be a plane deflection mirror or, alternatively, a mirror with a beam-influencing effect that goes beyond the purely deflecting effect. As an alternative or in addition thereto, the deflection mirror 19 can be embodied as a spectral filter separating a used light wavelength of the illumination radiation 16 from extraneous light having a wavelength that deviates therefrom. If the first facet mirror 20 is arranged in a plane of the illumination optical unit 4 that is optically conjugate to the object plane 6 as a field plane, it is also referred to as a field facet mirror. The first facet mirror 20 comprises a multiplicity of individual first facets 21, which are also referred to below as field facets. Some of these facets 21 are shown in Figure 1 only by way of example.

The first facets 21 may be embodied as macroscopic facets, in particular as rectangular facets or as facets with an arcuate peripheral contour or a peripheral contour of part of a circle. The first facets 21 may be embodied as plane facets or alternatively as convexly or concavely curved facets.

As known for example from DE 10 2008 009 600 A1, the first facets 21 themselves may also be composed in each case of a multiplicity of individual mirrors, in particular a multiplicity of micromirrors. The first facet mirror 20 may in particular be formed as a microelectromechanical system (MEMS system). For details, reference is made to DE 10 2008 009 600 A1.

Between the collector 17 and the deflection mirror 19, the illumination radiation 16 travels horizontally, that is to say along the y-direction.

In the beam path of the illumination optical unit 4, a second facet mirror 22 is arranged downstream of the first facet mirror 20. If the second facet mirror 22 is arranged in a pupil plane of the illumination optical unit 4, it is also referred to as a pupil facet mirror. The second facet mirror 22 may also be arranged at a distance from a pupil plane of the illumination optical unit 4. In this case, the combination of the first facet mirror 20 and the second facet mirror 22 is also referred to as a specular reflector. Specular reflectors are known from US 2006/0132747 A1, EP 1 614 008 B1 and US 6,573,978.

The second facet mirror 22 comprises a plurality of second facets 23. In the case of a pupil facet mirror, the second facets 23 are also referred to as pupil facets.

The second facets 23 can likewise be macroscopic facets, which can, for example, have a round, rectangular or hexagonal boundary, or alternatively be facets composed of micromirrors. In this regard, reference is likewise made to DE 10 2008 009 600 A1.

The second facets 23 may have planar or alternatively convexly or concavely curved reflection surfaces.

The illumination optical unit 4 consequently forms a twice-faceted system. This basic principle is also referred to as a honeycomb condenser (fly's eye integrator).

It may be advantageous to arrange the second facet mirror 22 not exactly in a plane that is optically conjugate to a pupil plane of the projection optical unit 10. In particular, the pupil facet mirror 22 can be arranged so as to be tilted relative to a pupil plane of the projection optical unit 7, as is described, for example, in DE 10 2017 220 586 A1.

The individual first facets 21 are imaged into the object field 5 with the aid of the second facet mirror 22. The second facet mirror 22 is the last beam-shaping mirror or else, in fact, the last mirror for the illumination radiation 16 in the beam path before the object field 5.

In a further embodiment of the illumination optical unit 4 that is not shown, a transmission optical unit contributing in particular to the imaging of the first facets 21 into the object field 5 may be arranged in the beam path between the second facet mirror 22 and the object field 5. The transmission optical unit may have exactly one mirror or else alternatively two or more mirrors, which are arranged one behind the other in the beam path of the illumination optical unit 4. The transmission optical unit may in particular comprise one or two normal-incidence mirrors (NI mirrors) and/or one or two grazing-incidence mirrors (GI mirrors).

In the embodiment shown in Figure 1, the illumination optical unit 4 has exactly three mirrors downstream of the collector 17, specifically the deflection mirror 19, the field facet mirror 20 and the pupil facet mirror 22.

The deflection mirror 19 can also be dispensed with in a further embodiment of the illumination optical unit 4, and so the illumination optical unit 4 can then have exactly two mirrors downstream of the collector 17, specifically the first facet mirror 20 and the second facet mirror 22.

As a rule, the imaging of the first facets 21 into the object plane 6 by means of the second facets 23 or using the second facets 23 and a transmission optical unit is only approximate imaging.

The projection optical unit 10 comprises a plurality of mirrors Mi, which are consecutively numbered in accordance with their arrangement in the beam path of the projection exposure apparatus 1.

In the example illustrated in Figure 1, the projection optical unit 10 comprises six mirrors M1 to M6. Alternatives with four, eight, ten, twelve or any other number of mirrors Mi are similarly possible. The penultimate mirror M5 and the last mirror M6 each have a through opening for the illumination radiation 16. The projection optical unit 10 is a double-obscured optical unit. The projection optical unit 10 has an image-side numerical aperture which is greater than 0.3 and which can also be greater than 0.6 and can, for example, be 0.7 or 0.75.

Reflection surfaces of the mirrors Mi can be embodied as free-form surfaces without an axis of rotational symmetry. Alternatively, the reflection surfaces of the mirrors Mi may be designed as aspherical surfaces with exactly one axis of rotational symmetry of the reflection surface form. Just like the mirrors of the illumination optical unit 4, the mirrors Mi may have highly reflective coatings for the illumination radiation 16. These coatings may be designed as multilayer coatings, in particular with alternating layers of molybdenum and silicon.

The projection optical unit 10 has a large object image offset in the y-direction between a y-coordinate of a center of the object field 5 and a y-coordinate of the center of the image field 11. In the y-direction, this object-image offset can be approximately the same size as a z-distance between the object plane 6 and the image plane 12.

In particular, the projection optical unit 10 may have an anamorphic form. In particular, it has different imaging scales βx, βy in the x- and y-directions. The two imaging scales βx, βy of the projection optical unit 10 preferably lie at (βx, βy) = (+/- 0.25, /+-0.125). A positive imaging scale β means imaging without an image reversal. A negative sign for the imaging scale β means imaging with an image reversal.

The projection optical unit 10 consequently leads to a reduction in size with a ratio of 4:1 in the x-direction, that is to say in a direction perpendicular to the scanning direction.

The projection optical unit 10 leads to a reduction in size of 8:1 in the y-direction, that is to say in the scanning direction.

Other imaging scales are similarly possible. Imaging scales with the same sign and the same absolute value in the x-direction and y-direction are also possible, for example with absolute values of 0.125 or of 0.25.

The number of intermediate image planes in the x-direction and in the y-direction in the beam path between the object field 5 and the image field 11 may be the same or, depending on the embodiment of the projection optical unit 10, may differ. Examples of projection optical units with different numbers of such intermediate images in the x- and y-directions are known from US 2018/0074303 A1.

In each case one of the pupil facets 23 is assigned to exactly one of the field facets 21 for forming in each case an illumination channel for illuminating the object field 5. In particular, this can yield illumination according to the Köhler principle. The far field is decomposed into a multiplicity of object fields 5 with the aid of the field facets 21. The field facets 21 produce a plurality of images of the intermediate focus on the pupil facets 23 respectively assigned thereto.

The field facets 21 are imaged, in each case by way of an assigned pupil facet 23, onto the reticle 7 in a manner such that they are superposed on one another for the purposes of illuminating the object field 5. The illumination of the object field 5 is in particular as homogeneous as possible. It preferably has a uniformity error of less than 2%. The field uniformity can be achieved by way of the superposition of different illumination channels.

The illumination of the entrance pupil of the projection optical unit 10 can be defined geometrically by way of an arrangement of the pupil facets. The intensity distribution in the entrance pupil of the projection optical unit 10 can be set by selecting the illumination channels, in particular the subset of the pupil facets which guide light. This intensity distribution is also referred to as illumination setting.

A likewise preferred pupil uniformity in the region of defined illuminated sections of an illumination pupil of the illumination optical unit 4 can be achieved by a redistribution of the illumination channels.

Further aspects and details of the illumination of the object field 5 and in particular of the entrance pupil of the projection optical unit 10 are described below.

In particular, the projection optical unit 10 may have a homocentric entrance pupil. The latter may be accessible. It may also be inaccessible.

The entrance pupil of the projection optical unit 10 cannot be exactly illuminated using the pupil facet mirror 22 on a regular basis. In the case of imaging the projection optical unit 10 in which the center of the pupil facet mirror 22 is telecentrically imaged onto the wafer 13, the aperture rays often do not intersect at a single point. However, it is possible to find an area in which the distance of the aperture rays determined in pairs becomes minimal. This area represents the entrance pupil or an area in real space that is conjugate thereto. In particular, this area has a finite curvature.

It may be that the projection optical unit 10 has different positions of the entrance pupil for the tangential beam path and for the sagittal beam path. In this case, an imaging element, in particular an optical component part of the transmission optical unit, should be provided between the second facet mirror 22 and the reticle 7. With the aid of this optical element, the different position of the tangential entrance pupil and the sagittal entrance pupil can be taken into account.

In the arrangement of the components of the illumination optical unit 4 illustrated in Figure 1, the pupil facet mirror 22 is arranged in an area conjugate to the entrance pupil of the projection optical unit 10. The field facet mirror 20 is arranged in tilted fashion with respect to the object plane 6. The first facet mirror 20 is arranged in tilted fashion with respect to an arrangement plane defined by the deflection mirror 19.

The first facet mirror 20 is arranged so as to be tilted in relation to an arrangement plane defined by the second facet mirror 22.

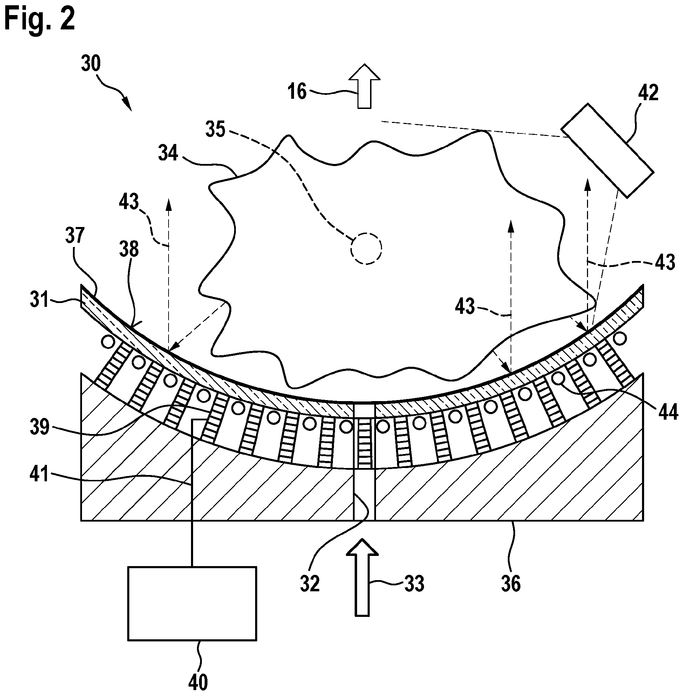

Figure 2 shows an inventive source module 30, which corresponds to a source module 3, 17 of the projection exposure apparatus 1 described in figure 1. The source module 30 comprises a collector mirror 31 with a recess 32. The recess 32 allows a laser beam 33 to irradiate onto a tin droplet 35 for generating an EUV-light 16 emitting plasma 34. The collector mirror 31 contains a reflective coating 37 on the optically active surface 38, which is the area of the collector mirror 31 used to reflect the emitted EUV-Light 16 from the plasma 34.

The collector mirror 31 is mounted into a holding frame 36, where the mirror 31 is connected to the holding frame 36 by piezo actuators 39. The piezo actuators 39 are connected via an electrical line 41 to an actuator control unit 40. The actuator control unit 40 can deflect the actuators individually and therefore the optical active surface 38 of the collector mirror 31 can be deformed.

Furthermore, the embodiment shown in figure 2 comprises fluid channels 44 located in the gaps between the actuators 39 in the space between the holding frame 36 and the collector mirror 31. Fluid is flowing through the fluid channels 44 to stabilize the temperature of the collector mirror 31 during system use. Further embodiments of the collector mirrors 31 may comprise fluid channels 44 within the body of the collector mirror 31.

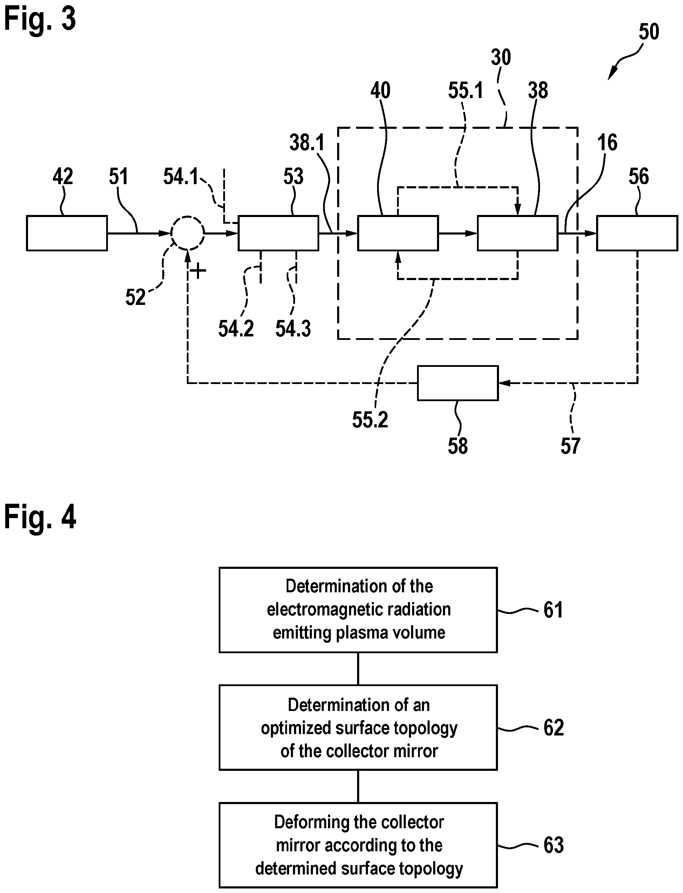

Additionally, the source module 30 comprises a plasma volume detection unit 42 to determine the size, shape, position and orientation of the plasma 34, where plasma and plasma volume will be defined by the reference sign 34. The plasma volume 34 can be determined by several two-dimensional measurements or a three-dimensional measurement. The actuator control unit 40 and the plasma volume detection unit 42 are both connected to a sensing system (not shown), which is designed to determine the optimum surface topology of the optically active surface 38, hereafter referred to as surface topology 38 of the mirror 31 based on surface topology 38, on the gained information of the plasma volume 34 and other parameters of the projection exposure apparatus 1. The sensing system will be explained in more detail in figure 3.

The source unit 30 is adjusted during set up of the projection exposure apparatus 1, while the position and distribution of EUV-Light 16 of the plasma 34 as well as the position and orientation of the collector mirror 31 is adjusted for maximum system power, which is mainly based on the quantity of emitted EUV-Light 16 from the collector mirror 31 into the illumination optical unit 4.

During use of the projection exposure apparatus 1 the system power is monitored continuously. In case system power decreases a global control (not shown), which will be described in more detail in Figure 3, determines if an adaption of the surface topology 38 of the collector mirror 31 is needed to improve the system power.

System power is based on many contributing parameters, but the main contributors are the plasma volume 34, the distribution of the emitted EUV-Light 16 from the plasma volume 34, the surface topology 38 of the collector mirror 31, and the knowledge of more and less contributing areas of the collector mirror 31. Further the mechanical and optical design has an influence on the system power, by demanding predetermined angles of incidence of the EUV-light 16 into the illumination optical unit 4 (figure 1) and possible clipping by apertures or else within the illumination optical unit 4 and/or the projection optical unit 10 (figure 1).

In case a change of surface topology 38 of the collector mirror 31 will improve system power the sensing unit 53 will determine the optimum surface topology 38.1 and the actuator control unit 40 deflects the actuators 39 to change the surface topology 38 to the predetermined surface topology 38.1 (figure 3).

The possibility of adapting the surface topology 38 of the collector mirror 31 has the advantage of continuously ensuring emitting the maximum EUV-light 16 possible into the illumination optical unit 4, as indicated in figure 2 by single rays 43 of EUV-Light 16 directed by the surface topology 38 in one common direction independent of the angle of incidence of the emitted ray 43 from the plasma 34. Therefore, maximum system power for the use of imaging structures onto the wafer, which can be seen as one of the leading parameters to maximize throughput, can be ensured. It is obvious, that in the case of other key performance indicators running out of specification it may be necessary to settle for less than the maximum power of EUV-light 16 in favor of other key performance indicators as uniformity of critical dimensions.

Another advantage of a deformable collector mirror 31 is that the so-called plasma design or plasma recipe can be improved, e.g. the spectral content or the size or shape of the plasma. Optimizing the size and shape of the plasma can be based on the corresponding possibilities of adapting the surface topology 38 of the collector mirror 31, leading to an optimized output of emitted EUV-light 16 from the plasma into the illumination optic unit 4. The optimization is not only driven by an increase of emitted EUV-light 16, but by an emission leading to an increase of EUV-light 16 at wafer level and/or at reticle level. This can also comprise a different emission profile from the collector mirror 31. In general, the surface topology 38 can be adapted to the plasma design and therefore the deformable collector mirror 31 can also be adapted for future plasma designs as well. Since the changes of plasma volume 34 during use and over time will be slow, there is no specific requirement on the time span needed to adapt the surface topology 38 of the deformable collector mirror 31.

Figure 3 shows an inventive EUV-Light emission control unit 50, hereafter referred to as emission control unit 50, to maximize EUV-Light 16 emitted from the collector mirror 31 (figure 2) to the illumination optical unit 4 of the projection exposure apparatus 1 (figure 1). The emission control unit 50 comprises a sensing unit 53, which determines the optimum surface topology 38.1 of the collector 31.

The main input to the sensing module 53 is the measurement 51 of the plasma volume 34 (figure 2) detected by the plasma volume detection unit 42, as described in figure 2. Besides this the sensing unit 53 obtains other input parameters 54.1, 54.2, 54.3 from different monitoring systems of the projection exposure apparatus as an input, all contributing to the system power and related to or corresponding with the surface topology 38 of the collector mirror 31. The input parameters could include a contribution map of the collector mirror 54.1, an emission 54.2 of EUV-light 16 at the edge of the collector mirror 31, system power 54.3 at reticle level or the position of actuatable components within the illumination optical unit 4 or the projection optical unit 10. The output of the sensing unit 53 is a surface topology 38.1 to be set by source module 30 in particular by deflecting the actuators 39 (figure 2). The corresponding actuator signals will be generated by the actuator control unit 40. In a further embodiment there can be a closed loop control 55.1, 55.2 implemented to control the surface topology 38 of the collector mirror 31, which is indicated by dashed arrows between the actuator control unit and the surface topology 38 in figure 3. It is obvious that some kind of monitoring/measuring device is needed to determine the surface topology 38. The output of the source module 30 is the emitted EUV-Light 16 reaching the optical system 56, in particular the illumination optical unit 4 and thereafter the projection optical unit 10 (figure 1) and irradiating the wafer 13 where the intensity of the EUV-Light 16 can be measured.

The intensity of EUV-Light 16 on wafer level is one indicator of throughput 57, which is one of the most important key performance indicators (KPI) of the projection exposure apparatus 1 (figure 1). The throughput 57 and many other parameters are processed in a global controller 58. In a further embodiment the control of the surface topology 38 can be in a closed loop with the global control 58 based on throughput 57. The feedback of the throughput 57 to the global control 58 is indicated by dashed arrows in figure 3. The global control 58 feeds back the throughput 57 to a connection point 52 of the EUV-light-emission control unit 50. Adding the deviation of the throughput 57 to the input of the sensing unit 53 will close the control loop of the throughput 57. In case the feedback loop of the global control 58 is closed the sensing unit 53 will also get the predetermined value of throughput 57 as a target value, as well as the deviation of the throughput 57. The EUV-light emission control unit 50 will be a sub-controller of the global control 58 in this setting.

Instead of throughput 57 any other KPI or any other system parameter of the projection exposure apparatus 1 could be used for a feed back control including optimizing the surface topology 38 of the collector mirror 31.

Because of the possibility of increasing the throughput 57 to an optimum at any time, the system performance of the projection exposure apparatus 1 can be kept within specification for a longer period of time. Changes in the plasma volume 34 can be corrected for by deforming the surface topology 38 (figure 2) of the mirror 31 based on the plasma volume measurement 51 and other parameters of the projection exposure apparatus 1. The improvement of the overall system performance results in a higher throughput and a significant extension of the service life of the projection exposure apparatus 1, which advantageously improves cost of ownership. Additionally, the deformable collector mirror 31 can also correct for decentration of the plasma 34 with respect to the collector mirror 31, which is significantly cheaper than adjusting the plasma 34. Furthermore, the possibilities of plasma design will be extended by the additional feature of deforming the collector mirror 31 and therefore being able to adapt to plasma design, leading to an improved throughput 57.

Figure 4 shows a possible method for optimizing the emission of electromagnetic radiation 16 from a plasma in a source 3 of an illumination system 2 of a projection exposure apparatus 1, the illumination system 2 comprising a collector mirror 17, 31.

In a first step 61 the EUV-light 16 emitting plasma volume 34 is determined. There are several methods known from the prior art to determine the plasma volume 34. A common method is to use scintillators (e.g. YAG:Ce crystals), which fluoresce in the visible spectrum when irradiated by EUV-Light 16. This visible radiation can easily be imaged by a high-resolution off-the-shelf camera. Furthermore, more than one camera may be used in the system, such that a 3D distribution can be reconstructed.

In a second step 62 an optimized surface topology 38.1 of the collector mirror 31 would be determined based on the plasma volume 34.

In a third step 63 the surface topology 38 of the collector mirror 31 would be adapted according to the determined surface topology 38.1. This can be caused by the deflection of the actuators 39 as described in figure 2.

### List of reference signs

- 1: Projection exposure apparatus
- 2: Illumination system
- 3: Radiation source
- 4: Illumination optical unit
- 5: Object field
- 6: Object plane
- 7: Reticle
- 8: Reticle holder
- 9: Reticle displacement drive
- 10: Projection optical unit
- 11: Image field
- 12: Image plane
- 13: Wafers
- 14: Wafer holder
- 15: Wafer displacement drive
- 16: EUV radiation
- 17: Collector
- 18: Intermediate focal plane
- 19: Deflection mirror
- 20: Facet mirror
- 21: Facets
- 22: Facet mirror
- 23: Facets
- 30: Source module
- 31: Collector mirror
- 32: Recess for laser
- 33: Laser beam
- 34: Plasma
- 35: Tin droplet
- 36: Holding frame
- 37: Coating
- 38, 38.1: Active surface/surface topology
- 39: Piezo actuator
- 40: Actuator control unit
- 41: Connection actuator control unit
- 42: Plasma volume detection unit
- 43: Single rays of EUV-Light
- 44: Fluid channels
- 50: EUV-Light-Emission control unit
- 51: Measurement plasma volume
- 52: Feedback summation point
- 53: Sensing unit
- 54.1-54.3: Input to sensing unit
- 55.1, 55.2: Feedback connection for deformable mirror
- 56: EUV-System
- 57: Feedback connection for KPI
- 58: Global control
- 61: Process step 1
- 62: Process step 2
- 63: Process step 3

## Claims

1. Method for optimizing the emission of electromagnetic radiation (16) of a plasma (34) in a source (4) of an illumination system (2) of a projection exposure apparatus (1), whereas the illumination system (2) comprises a collector mirror (31), the method comprising following steps:
- Determination of the electromagnetic radiation (16) emitting plasma volume (34),
- Determination of an optimized surface topology (38.1) of the collector mirror
- Deforming the collector mirror (31) according to the determined surface topology (38.1)

2. Method according to claim 1,
**characterized in that**,
the emitting plasma volume (34) is measured in two dimensions.

3. Method according to claim 1 or 2,
**characterized in that**,
the emitting plasma volume (34) is measured in three dimensions.

4. Method according to one of the preceding claims,
**characterized in that**,
a contribution map (54.1) of the amount of reflected EUV-Light (16) of the collector mirror (31) to system power is determined and used as an input to determine the optimized surface topology (38.1).

5. Method according to one of the preceding claims,
**characterized in that**,
the restrictions of the mechanical and optical design of an optical system (4,10) of the projection exposure apparatus (1) are used as an input to determine the optimized surface topology (38.1).

6. Method according to one of the preceding claims,
**characterized in that**,
the surface topology (38) is controlled in an open control loop.

7. Method according to one of the claims 1 to 5,
**characterized in that**,
the surface topology (38) is controlled in a closed control loop.

8. Method according to claim 6 or 7,
**characterized in that**,
the control of surface topology (38) is part of a closed loop control of a key performance indicator of the projection exposure apparatus (1) dependent on the surface topology (38).

9. Source module (30) with a collector mirror (31), whereas the source is a plasma source and the collector mirror (31) is the first mirror after the source,
**characterized in that**
the collector mirror (31) is deformable.

10. Source module (30) according to claim 9,
**characterized in that**
the collector mirror (31) comprises at least one piezoelectric actuator (39) to deform a reflective surface (38) of the collective mirror (31).

11. Source module (30) according to claim 10,
**characterized in that**
the source module (30) comprises an actuator control unit (40) to control the actuators (39).

12. Source module (30) according to one of the claims 9 to 11, **characterized in that**
the source module (30) comprises a plasma volume detection unit (42).

13. Source module (30) according to one of the claims 9 to 12,
**characterized in that**
the source module (30) comprises a EUV-light emission control unit (50).

14. Source module (30) according to claim 13,
**characterized in that**
the EUV-light emission control unit (50) comprises a sensing unit (53).

15. Source module (30) according to one of the claims 9 to 14,
**characterized in that**
the source module (30) comprises fluid channels (44) for temperature control of the collector mirror (31).

16. Illumination system (2) comprising a source module (30) according to one of the claims 9 to15.

17. Projection exposure apparatus (1) comprising an illumination system (2) according to claim 16.

18. Projection exposure apparatus according (1) to claim 17,
**characterized in that**
the projection exposure apparatus (1) comprises a global control (58) designed to control at least one system performance indicator, whereas the global control (58) includes the EUV-light emission control unit (50) as a sub control loop.
